# EUROPEAN PATENT APPLICATION

(11) **EP 2 528 114 A2**
(43) Date of publication of application: **28.11.2012**
(21) Application number: 12151758.5
(22) Date of filing: 19.01.2012
(51) Int. Cl.: H01L 33/20, H01L 33/22, H01L 33/00, H01L 33/44

(54) **Light emitting device, light emitting device package, and light unit**

(30) Priority: 23.05.2011 KR 20110048694; 30.06.2011 KR 20110064597
(71) Applicant: LG Innotek Co., Ltd., Seoul 100-714 (KR)
(72) Inventor: Kim, Tae Jin, 100-714 Seoul (KR); Park, Q Han, 100-714 Seoul (KR)
(74) Representative: Cabinet Plasseraud

(57) **Abstract**

Provided are a light emitting device, a light emitting device package, and a light unit. The light emitting device includes: a light emitting structure (10)including a first conductive semiconductor layer (11), an active layer (12) on the first conductive semiconductor layer, and a second conductive semiconductor layer (13) on the active layer; a first electrode (20) electrically connected to the first conductive semiconductor layer; and a second electrode electrically connected to the second conductive semiconductor layer. A surface (11a) of the light emitting structure has a plurality of first sides and second sides having curvatures in respectively different directions, which are alternately disposed.

## Description

### BACKGROUND

The present disclosure relates to a light emitting device, a light emitting device package, and a light unit.

As one of a light emitting device, a light emitting diode (LED) is extensively used. The LED converts an electrical signal into light such as infrared rays or visible rays through characteristics of compound semiconductors.

As the light efficiency of a light emitting device is required than ever before, the LED is now in use for various fields such as display devices and lighting devices.

### SUMMARY

Embodiments provide a light emitting device, a light emitting device package, and a light unit, with a new structure.

Embodiments also provide a light emitting device, a light emitting device package, and a light unit, with improved light extraction efficiency and broader angle for light extraction.

In one embodiment, a light emitting device comprises: a light emitting structure comprising a first conductive semiconductor layer, an active layer below the first conductive semiconductor layer, and a second conductive semiconductor layer below the active layer; a first electrode electrically connected to the first conductive semiconductor layer; and a second electrode electrically connected to the second conductive semiconductor layer, wherein a top surface of the first conductive semiconductor layer has a curve with a continuous slope change and unevenness is provided on a top surface of the first conductive semiconductor layer.

In another embodiment, a light emitting device comprises: a light emitting structure comprising a first conductive semiconductor layer, an active layer on the first conductive semiconductor layer, and a second conductive semiconductor layer on the active layer; a first electrode electrically connected to the first conductive semiconductor layer; and a second electrode electrically connected to the second conductive semiconductor layer, wherein a surface of the light emitting structure has a plurality of first sides and second sides having curvatures in respectively different directions, which are alternately disposed.

In further another embodiment, a light emitting device package comprises: a main body; a light emitting device on the main body; first and second lead electrodes electrically connected to the light emitting device, wherein the light emitting device comprises: a light emitting structure comprising a first conductive semiconductor layer, an active layer below the first conductive semiconductor layer, and a second conductive semiconductor layer below the active layer; a first electrode electrically connected to the first conductive semiconductor layer; and a second electrode electrically connected to the second conductive semiconductor layer, wherein a top surface of the first conductive semiconductor layer has a curve with a continuous slope change and unevenness is provided on a top surface of the first conductive semiconductor layer.

In still further another embodiment, a light emitting device package comprises: a main body; a light emitting device on the main body; first and second lead electrodes electrically connected to the light emitting device, wherein the light emitting device comprises: a light emitting structure comprising a first conductive semiconductor layer, an active layer on the first conductive semiconductor layer, and a second conductive semiconductor layer on the active layer; a first electrode electrically connected to the first conductive semiconductor layer; and a second electrode electrically connected to the second conductive semiconductor layer, wherein a surface of the light emitting structure has a plurality of first sides and second sides having curvatures in respectively different directions, which are alternately disposed. A top surface of the first conductive semiconductor layer has a curve with a continuous slope change and unevenness is provided on a top surface of the first conductive semiconductor layer.

In still further another embodiment, a light unit comprises: a board; a light emitting device on the board; and an optical member through which a light from the light emitting device passes, wherein the light emitting device comprises: a light emitting structure comprising a first conductive semiconductor layer, an active layer below the first conductive semiconductor layer, and a second conductive semiconductor layer below the active layer; a first electrode electrically connected to the first conductive semiconductor layer; and a second electrode electrically connected to the second conductive semiconductor layer, wherein a top surface of the first conductive semiconductor layer has a curve with a continuous slope change and unevenness is provided on a top surface of the first conductive semiconductor layer.

In still further another embodiment, a light unit comprises: a board; a light emitting device on the board; and an optical member through which a light from the light emitting device passes, wherein the light emitting device comprises: a light emitting structure comprising a first conductive semiconductor layer, an active layer on the first conductive semiconductor layer, and a second conductive semiconductor layer on the active layer; a first electrode electrically connected to the first conductive semiconductor layer; and a second electrode electrically connected to the second conductive semiconductor layer, wherein a surface of the light emitting structure has a plurality of first sides and second sides having curvatures in respectively different directions, which are alternately disposed.

In still further another embodiment, the top surface of the first conductive semiconductor layer has a sectional upper side in a first direction having a curve with a continuous slope change and a sectional upper side in a second direction having a curve with a continuous slope change.

In still further another embodiment, the top surface of the first conductive semiconductor layer has a sectional upper side in a first direction having a curve with a continuous slope change and a sectional upper side in a second direction having lines with respectively different slopes.

In still further another embodiment, the top surface of the first conductive semiconductor layer has a curved surface of a repeated predetermined shape.

In still further another embodiment, the unevenness has a height of 0.8 µm to 1.2 µm.

In still further another embodiment, the unevenness has a period of 0.8 µm to 1.2 µm.

In still further another embodiment, it further comprises a current blocking layer below the second conductive semiconductor layer.

In still further another embodiment, it further comprises an ohmic contact layer between the second conductive semiconductor layer and the second electrode and between the current blocking layer and the second electrode.

In still further another embodiment, the current blocking layer and the first electrode partially overlap each other in a vertical direction.

In still further another embodiment, the current blocking layer has electrical insulation or provides Schottky contact with the light emitting structure.

In still further another embodiment, the first electrode contacts the first conductive semiconductor layer.

In still further another embodiment, the second electrode contacts the second conductive semiconductor layer.

The details of one or more embodiments are set forth in the accompanying drawings and the description below. Other features will be apparent from the description and drawings, and from the claims.

### BRIEF DESCRIPTION OF THE DRAWINGS

Fig. 1 is view of a light emitting device according to an embodiment.

Figs. 2 and 3 are views illustrating a modification example of the light emitting structure of Fig. 1.

Figs. 4 to 11 are views illustrating a method of manufacturing a light emitting device according to an embodiment.

Fig. 12 is a view illustrating another example of a light emitting device according to an embodiment.

Fig. 13 is a view illustrating a structure of a portion A of Fig. 12.

Fig. 14 is a view illustrating a structure of '122a' of Fig. 13.

Fig. 15 is a view illustrating a structure of '122b' of Fig. 13.

Fig. 16 is a view illustrating another example of a structure of a potion A of Fig. 12.

Fig 17 is a perspective view of a light emitting structure having the structure of Fig. 13 applied.

Fig 18 is a perspective view of a light emitting structure having the structure of Fig. 16 applied.

Fig. 19 is a view illustrating a light emitting device package having a light emitting device is applied according to an embodiment.

Fig. 20 is a view illustrating an example of a display device having a light emitting device applied according to an embodiment.

Fig. 21 is a view illustrating another example of a display device having a light emitting device applied according to an embodiment.

Fig. 22 is a view illustrating an example of a lighting device having a light emitting device applied according to an embodiment.

Fig. 23 is a view illustrating another example of a lighting device having a light emitting device applied according to an embodiment.

### DETAILED DESCRIPTION OF THE EMBODIMENTS

In the description of embodiments, it will be understood that when a layer (or film), region, pattern or structure is referred to as being 'on' or 'under' another layer (or film), region, pad or pattern, the terminology of 'on' and 'under' comprises both the meanings of 'directly' and 'indirectly'. Further, the reference about 'on' and 'under' each layer will be made on the basis of drawings.

In the drawings, the thickness or size of each layer may be exaggerated, omitted, or schematically illustrated for convenience in description and clarity. Also, the size of each element does not entirely reflect an actual size.

Hereinafter, a light emitting device, a light emitting device package, and a light unit, and a method of manufacturing the light emitting device will be described in more detail with reference to the accompanying drawings.

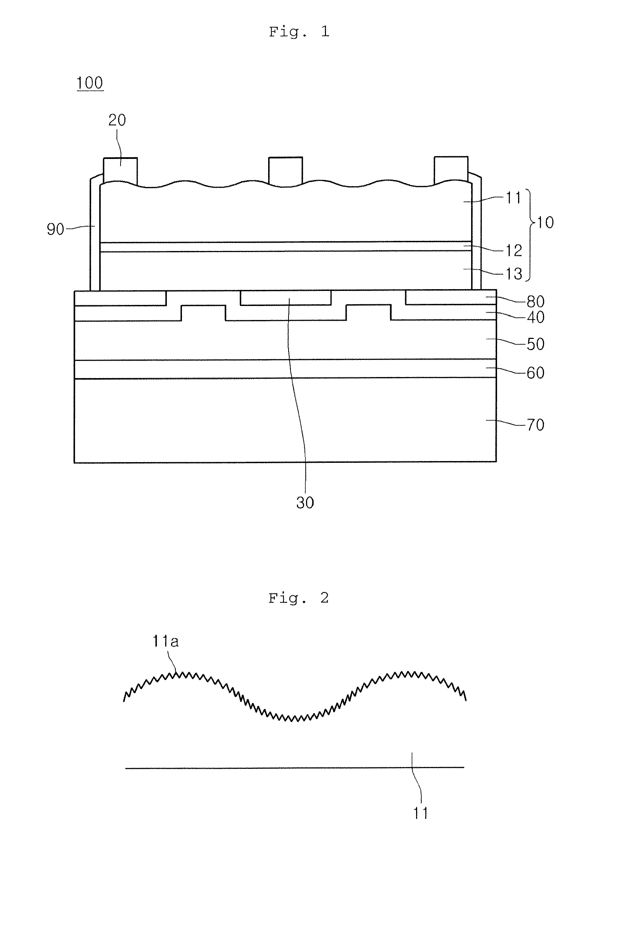

Fig. 1 is a view of a light emitting device according to an embodiment.

The light emitting device 100 may comprise a light emitting structure 10, an electrode 20, and a reflective electrode 50, as shown in Fig. 1. Additionally, the light emitting device 100 may further comprise a current blocking layer 30, and an ohmic contact layer 40.

The light emitting structure 10 may comprise a first conductive semiconductor layer 11, an active layer 12, and a second conductive semiconductor layer 13. For example, the first conductive semiconductor layer 11 may be an n-type semiconductor layer doped with an n-type dopant as a first conductive dopant, and the second conductive semiconductor layer 13 may be a p-type semiconductor layer doped with a p-type dopant as a second conductive dopant. Additionally, the first conductive semiconductor layer I may be a p-type semiconductor layer and the second conductive semiconductor layer 13 may be an n-type semiconductor layer.

The first conductive semiconductor layer I may comprise an n-type semiconductor layer, for example. The first conductive semiconductor layer 11 may be formed of a compound semiconductor. The first conductive semiconductor layer 11 may be formed of a Group III-V compound semiconductor. The first conductive semiconductor layer 11 may be formed of a Group II-VI compound semiconductor. The first conductive semiconductor layer 11 may be formed of one selected from semiconductor materials having the empirical formula, InₓAlyGa_{1-x-y}N (0≤x≤1, 0≤y≤1, 0≤x+y≤1), for example, InAlGaN, GaN, AlGaN, AlInN, InGaN, AlN, and InN, and may be doped with an n-type dopant such as Si, Ge, and Sn.

The active layer 12 is a layer where electrons (or holes) injected through the first conductive semiconductor layer 11 and holes (or electrons) injected through the second conductive semiconductor layer 13 collide with each other to emit light, which is due to an energy band gap difference according to a forming material of the active layer 12. The active layer 12 may have one of a single well structure, a multi well structure, a quantum dot structure, and a quantum wire structure, but is not limited thereto.

The active layer 12 may be formed of a compound semiconductor. The active layer 12 may be formed of semiconductor materials having the empirical formula, InₓAl_{y}Ga_{1-x-y}N (0≤x≤1, 0≤y≤1, 0≤x+y≤1). If the active layer 12 has the multi well structure, it may be realized by stacking a plurality of well layers and a plurality of barrier layers, for example, in a period of InGaN well layer/GaN barrier layer.

The second conductive semiconductor layer 13 may comprise a p-type semiconductor layer, for example. The second conductive semiconductor layer 13 may be formed of a compound semiconductor. The second conductive semiconductor layer 13 may be formed of a Group III-V compound semiconductor. The second conductive semiconductor layer 13 may be formed of a Group II-VI compound semiconductor. The second conductive semiconductor layer 13 may be formed of one selected from semiconductor materials having the empirical formula, InₓAl_{y}Ga_{1-x-y}N (0≤x≤1, 0≤y≤1, 0≤x+y≤1), for example, InAlGaN, GaN, AlGaN, InGaN, AlInN, AlN, and InN, and may be doped with a p-type dopant such as Mg, Zn, Ca, Sr, and Ba.

Additionally, the first conductive semiconductor layer 11 may be a p-type semiconductor layer and the second conductive semiconductor layer 13 may be an n-type semiconductor layer. Additionally, a semiconductor layer including an n-type or p-type semiconductor layer may be further formed below the second conductive semiconductor layer 13. Accordingly, the light emitting structure 10 may have at least one of np, pn, npn, and pnp junction structures. Additionally, a doping concentration of an impurity in the first conductive semiconductor layer 11 and the second conductive semiconductor layer 13 may be uniform or irregular. That is, the light emitting structure 10 may have various structures, and that is, the present invention does not limit its structure.

Additionally, a first conductive InGaN/GaN or InGaN/InGaN super lattice structure may be formed between the first conductive semiconductor layer 11 and the active layer 12. Moreover, a second conductive AlGaN layer may be formed between the second conductive semiconductor layer 13 and the active layer 12.

The ohmic contact layer 40 and the reflective electrode 50 may be disposed below the light emitting structure 10. The electrode 20 may be disposed on the light emitting structure. The electrode 20 and the reflective electrode 50 may provide power to the light emitting structure 10. The ohmic contact layer 40 may be formed to ohmic-contact the light emitting structure 10. Moreover, the reflective electrode 50 may serve to increase the amount of light extracted to the external by reflecting the incident light from the light emitting structure 10.

The ohmic contact layer 40 may be formed of a transparent conductive oxide layer, for example. The ohmic contact layer 40 may be formed of at least one selected from Indium Tin Oxide (ITO), Indium Zinc Oxide (IZO), Aluminum Zinc Oxide (AZO), Aluminum Gallium Zinc Oxide (AGZO), Indium Zinc Tin Oxide (IZTO), Indium Aluminum Zinc Oxide (IAZO), Indium Gallium Zinc Oxide (IGZO), Indium Gallium Tin Oxide (IGTO), Antimony Tin Oxide (ATO), Gallium Zinc Oxide (GZO), IZO Nitride (IZON), ZnO, IrOₓ, RuOₓ, and NiO.

The reflective electrode 50 may be formed of a metallic material having high reflectivity. For example, the reflective electrode 50 may be formed of a metal or an alloy including at least one of Ag, Ni, Al, Rh, Pd, Ir, Ru, Mg, Zn, Pt, Cu, Au, and Hf. Moreover, the reflective electrode 50 may comprise a multilayer formed of the metal, the alloy, or a transparent conductive material such as Indium-Tin-Oxide (ITO), Indium-Zinc-Oxide (IZO), Indium-Zinc-Tin-Oxide (IZTO), Indium-Aluminum-Zinc-Oxide (IAZO), Indium-Gallium-Zinc-Oxide (IGZO), Indium-Gallium-Tin-Oxide (IGTO), Aluminum-Zinc-Oxide (AZO), and Antimony-Tin-Oxide (ATO). For example, the reflective electrode 50 may comprise at least one of Ag, Al, a Ag-Pd-Cu alloy, and a Ag-Cu alloy.

The current blocking layer (or CBL) 30 may be disposed between the light emitting structure 10 and the ohmic contact layer 40. The current blocking layer 30 may be formed in an area where it may partially overlap the electrode 20 in a vertical direction. Accordingly, this may alleviate the phenomenon that current concentrates in the shortest distance between the electrode 20 and the reflective electrode 40, so that the light emitting efficiency of a light emitting device according to an embodiment may be improved.

The current blocking layer 30 may be formed of a material having electrical insulation or a material used for forming Schottky contact on the light emitting structure 10. The current blocking layer 30 may be formed of oxide, nitride, or metal. The current blocking layer 30 may comprise at least one of SiO₂, SiOₓ, SiO_{X}N_{y}, Si₃N₄, Al₂O₃, TiOₓ, Ti, Al, and Cr, for example.

The current blocking layer 30 may be disposed in a first area below the light emitting structure 10, and the ohmic contact layer 40 may be in a second area below the light emitting structure 10 and below the current blocking layer 30. The ohmic contact layer 40 may be disposed between the light emitting structure 10 and the reflective electrode 50. Additionally, the ohmic contact layer 40 may be disposed between the current blocking layer 30 and the reflective electrode 50.

An isolation layer 80 may be further disposed between the light emitting structure 10 and the ohmic contact layer 40. The isolation layer 80 may be disposed below the lower circumference of the light emitting structure 10 and on the ohmic contact layer 40. The isolation layer 80 may be formed of a material having electrical insulation or a material having a lower electrical conductivity than the light emitting structure 10, for example. The isolation layer 80 may be formed of oxide or nitride, for example. For example, the isolation layer 80 may be formed of at least one selected from the group consisting of SiO_{2,} SiₓO_{y}, Si₃N_{4.} SiₓN_{y}, SiOₓN_{y}, Al₂O₃, TiO₂, ITO, AZO, and ZnO. The isolation layer 80 may be formed of the same material as or a different material from the current blocking layer 30. The isolation layer 80 may be designated as a channel layer.

A bonding layer 60 and a conductive supporting member 70 may be disposed below the reflective electrode 50. The bonding layer 60 may comprise a barrier metal or a bonding metal, and for example, may comprise at least one of Ti, Au, Sn, Ni, Cr, Ga, In, Bi, Cu, Ag and Ta. The conductive supporting member 70 supports a light emitting device according to an embodiment and is electrically connected to an external electrode to provide power to the light emitting structure 10. The conductive supporting member 70 may be formed of at least one of carrier wafers (formed of Si, Ge, GaN, GaAs, ZnO, SiC, or SiGe) having Ti, Cr, Ni, Al, Pt, Au, W, Cu, Mo, Cu-W or impurity injected.

A protective layer 90 may be further disposed on the light emitting structure 10. The protective layer 90 may be formed of oxide or nitride, for example. The protective layer 90 may be formed of a material having transmittance and insulation such as SiO₂, SiOₓ, SiOₓN_{y}, Si₃N₄, and Al₂O₃. The protective layer 90 may be disposed on the lateral side of the light emitting structure 10. Additionally, the protective layer 90 may be disposed on the lateral side and the upper side of the light emitting structure 10.

The light emitting structure 10 may have a curved top surface. The light emitting structure 10 may have a curved top surface with a continuous slope change. Like this, since the light emitting structure 10 may have a curved surface not a flat surface, light extraction efficiency may be improved. This is because the light propagated through the light emitting structure 10 is more extracted to the external due to a change of an incident angel at which the light is incident to the curved top surface of the light emitting structure 10, compared to when the light is incident to the flat top surface of the light emitting structure 10. Additionally, the amount of light extracted to the external becomes increased, and also, the light extraction angle becomes broader. That is, as the light emitting structure 10 has the curved top surface, the width of the light extraction angle becomes broader.

The top surface of the light emitting structure 10 has a sectional upper side in a first direction having a curve with a continuous slope change and a sectional upper side in a second direction having a curve with a continuous slope change. Herein, the second direction may be perpendicular to the first direction. Additionally, the second direction may have an arbitrary angle with respect to the first direction, not the right angle.

A light emitting device according to an embodiment may have a sectional upper side of the light emitting structure 10, which has a curve with a continuous slope change, as shown in Fig. 2. Additionally, an unevenness 11a may be provided on the top surface of the first conductive semiconductor layer I in the light emitting structure 10. Like this, as the unevenness 11a is provided on the top surface of the first conductive semiconductor layer 11, the amount of light extracted to the external through the first conductive semiconductor layer 11 may be further increased. Additionally, the amount of light extracted to the external is increased, and also, the light extraction angle becomes broader. That is, as the light emitting structure 10 has the curved top surface, the width of the light extraction angle becomes broader.

The unevenness 11a may have a height of about 0.8 µm to about 1.2 µm. Additionally, the unevenness 11a may be in a period of about 0.8 µm to about 1.2 µm. For example, the first conductive semiconductor layer 11 may have the top surface with a wave-like curve, and the fine unevenness 11a may be further provided on the wave-like top surface.

Moreover, the top surface of the light emitting structure 10 has a sectional upper side in a first direction having a curve with a continuous slope change and a sectional upper side in a second direction having lines with respectively different slopes. Herein, the second direction may be perpendicular to the first direction. Additionally, the second direction may have an arbitrary angle with respect to the first direction, not the right angle.

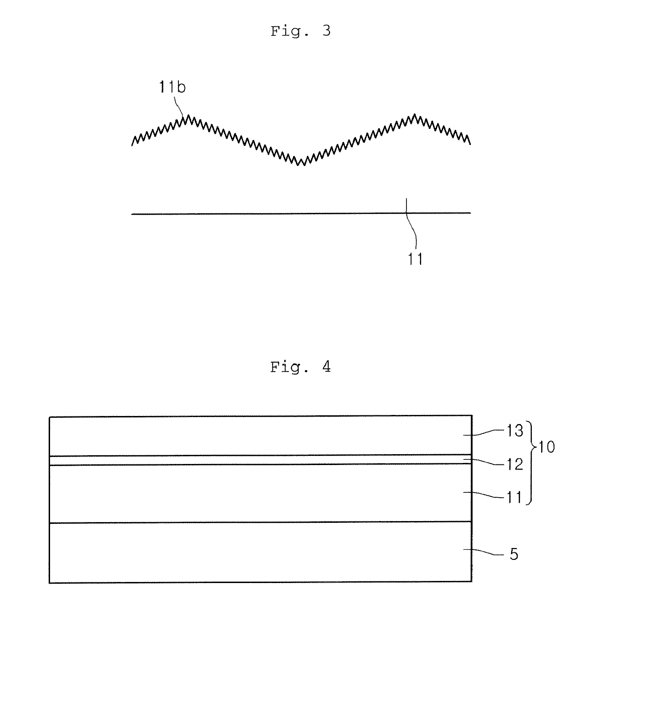

A light emitting device according to an embodiment may have a sectional upper side of the light emitting structure 10, which has lines with respectively different slopes, as shown in Fig. 3. Additionally, an unevenness 11b may be provided on the top surface of the first conductive semiconductor layer 11 in the light emitting structure 10. Like this, as the unevenness 11b is provided on the top surface of the first conductive semiconductor layer 11, the amount of light extracted to the external through the first conductive semiconductor layer 11 may be further increased. Additionally, the amount of light extracted to the external is increased, and also, the light extraction angle becomes broader. That is, as the light emitting structure 10 has the top surface with inclined lines, the width of the light extraction angle becomes broader.

The unevenness 11b may have a height of about 0.8 µm to about 1.2 µm. Additionally, the unevenness 11b may be in a period of about 0.8 µm to about 1.2 µm. For example, the first conductive semiconductor layer 11 may have the top surface with respectively different inclined lines, and the fine unevenness 11b may be further provided on the line-shaped top surface.

Moreover, in relation to a light emitting device according to an embodiment, the light emitting structure 100 may have a top surface with a curve of a repeated predetermined shape. That is, the light emitting structure 10 may have a top surface with a repeated wave-like shape. Additionally, the light emitting structure 10 may have a top surface with repeated various shapes such as a spherical lens shape, a concave lens shape, a convex lens shape, and a lenticular lens shape.

For example, when the light emitting structure 10 has a top surface with a concave sphere, a curved surface having a period of a height of about 1 µm to about 2 µm and a width of about 10 µm to about 50 µm may be formed and then a fine unevenness may be formed on the curved surface.

In the above description, a vertical type light emitting device, where the electrode 20 is disposed on the light emitting structure 10 and the reflective electrode 50 is disposed below the light emitting structure 10, was exemplarily described. However, in relation to the light emitting device 100 according to this embodiment, the positions and shapes of a first electrode connected electrically to the first conductive semiconductor layer 11 and a second electrode connected electrically to the second conductive semiconductor layer 12 in the light emitting structure 10 may vary. Furthermore, the light emitting device 100 according to this embodiment may be applied to a parallel type light emitting device where a first electrode and a second electrode are exposed in the same direction.

A method of manufacturing a light emitting device according to an embodiment will be described with reference to Figs. 4 to 11.

According to the method of manufacturing a light emitting device, as shown in Fig. 4, a first conductive semiconductor layer 11, an active layer 12, and a second conductive semiconductor layer 13 are formed on a substrate 5. The light emitting structure 10 may comprise the first conductive semiconductor layer 11. the active layer 12, and the second conductive semiconductor layer 13.

The substrate 5 may be formed of at least one of Al₂O₃, SiC, GaAs, GaN, ZnO, Si, GaP, InP, and Ge, and is not limited thereto. A buffer layer may be further formed between the first conductive semiconductor layer 11 and the substrate 5.

For example, the first conductive semiconductor layer 11 may be an n-type semiconductor layer doped with an n-type dopant as a first conductive dopant, and the second conductive semiconductor layer 13 may be a p-type semiconductor layer doped with a p-type dopant as a second conductive dopant. Additionally, the first conductive semiconductor layer 11 may be a p-type semiconductor layer and the second conductive semiconductor layer 13 may be an n-type semiconductor layer.

The first conductive semiconductor layer 11 may comprise an n-type semiconductor layer, for example. The first conductive semiconductor layer 11 may be formed of semiconductor materials having the empirical formula, InₓAl_{y}Ga_{1-x-y}N (0≤x≤1, 0≤y≤1, 0≤X+y≤1). The first conductive semiconductor layer 11 may be formed of one of InAlGaN, GaN, AlGaN, AlInN, InGaN, AlN, and InN, and may be doped with an n-type dopant such as Si, Gen, and Sn.

The active layer 12 is a layer where electrons (or holes) injected through the first conductive semiconductor layer 11 and holes (or electrons) injected through the second conductive semiconductor layer 13 collide with each other to emit light which is due to an energy band gap difference according to a forming material of the active layer 12. The active layer 12 may have one of a single well structure, a multi well structure, a quantum dot structure, and a quantum wire structure, but is not limited thereto.

The active layer 12 may be formed of semiconductor materials having the empirical formula, InₓAl_{y}Ga_{1-x-y}N (0≤x≤1, 0≤y≤1, 0≤x+y≤1). If the active layer 12 has the multi well structure, it may be realized by stacking a plurality of well layers and a plurality of barrier layers, for example, in a period of InGaN well layer/GaN barrier layer.

The second conductive semiconductor layer 13 may comprise a p-type semiconductor layer, for example. The first conductive semiconductor layer 13 may be formed of semiconductor materials having the empirical formula, InₓAl_{y}Ga_{1-x-y}N (0≤x≤2, 0≤y≤1 , 0≤x+y≤1). The second conductive semiconductor layer 13 may be formed of one of InAlGaN, GaN, AlGaN, InGaN, AlInN, AlN, and InN, and may be doped with a p-type dopant such as Mg, Zn, Ca, Sr, and Ba.

Additionally, the first conductive semiconductor layer 11 may be a p-type semiconductor layer and the second conductive semiconductor layer 13 may be an n-type semiconductor layer. Additionally, a semiconductor layer including an n-type or p-type semiconductor layer may be further formed on the second conductive semiconductor layer 13, and accordingly, the light emitting structure 10 may have at least one of np, pn, npn, and pnp structures. Additionally, a doping concentration of an impurity in the first conductive semiconductor layer 11 and the second conductive semiconductor layer 13 may be uniform or irregular. That is, the light emitting structure 10 may have various structures, and that is, the present invention does not limit its structure.

Additionally, a first conductive InGaN/GaN or InGaN/InGaN super lattice structure may be formed between the first conductive semiconductor layer 11 and the active layer 12. Moreover, a second conductive AlGaN layer may be formed between the second conductive semiconductor layer 13 and the active layer 12.

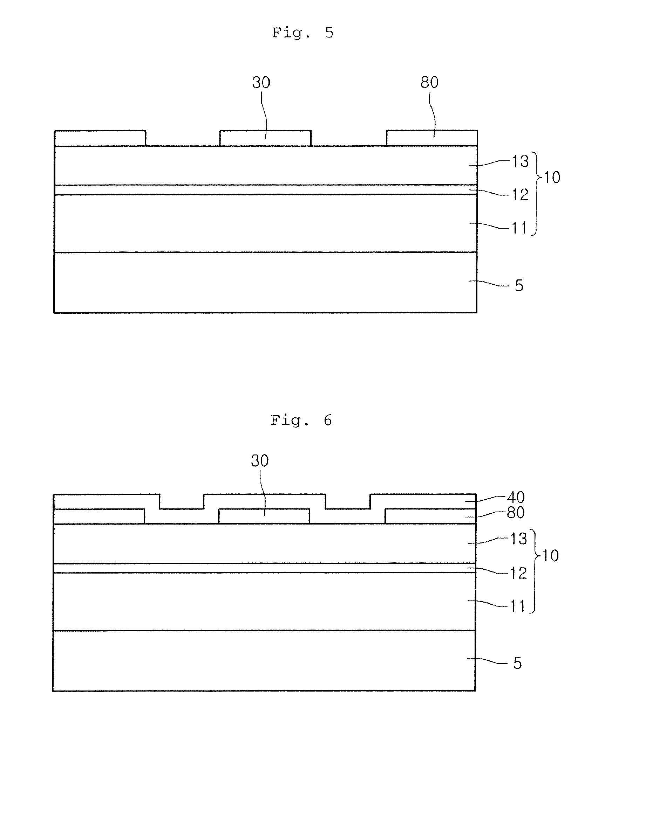

Then, as shown in Fig. 5, a current blocking layer 30 is formed on the second conductive semiconductor layer 13, and then, an isolation layer 80 is formed on the second conductive semiconductor layer 13. The current blocking layer 30 and the isolation layer 80 may be selectively formed. The current blocking layer 30 and the isolation layer 80 may be simultaneously or sequentially formed.

The current blocking layer 30 may be formed of a material having electrical insulation or a material used for forming Schottky contact on the light emitting structure 10. The current blocking layer 30 may be formed of oxide, nitride, or metal. The current blocking layer 30 may comprise at least one of SiO₂, SiOₓ, SiOₓN_{y}, Si₃N₄, Al₂O₃, TiOₓ, Ti, Al, and Cr, for example. The isolation layer 80 may be formed of a material having electrical insulation or a material having a lower electrical conductivity than the light emitting structure 10, for example. The isolation layer 80 may be formed of oxide or nitride, for example. For example, the isolation layer 80 may be formed of at least one selected from the group consisting of SiO₂, SiₓO_{y}, Si₃N₄, SiₓN_{y}, SiOₓN_{y}, Al₂O₃, TiO₂, ITO, AZO, and ZnO. The isolation layer 80 may be formed of the same material as or a different material from the current blocking layer 30. The isolation layer 80 may be designated as a channel layer.

Then, as shown in Fig. 6, an ohmic contact layer 40 is formed on the current blocking layer 30 and the isolation layer 80.

The ohmic contact layer 40 may be formed to ohmic-contact the light emitting structure 10. The ohmic contact layer 40 may be formed of a transparent conductive oxide layer, for example. The ohmic contact layer 40 may be formed of at least one selected from Indium Tin Oxide (ITO), Indium Zinc Oxide (IZO), Aluminum Zinc Oxide (AZO), Aluminum Gallium Zinc Oxide (AGZO), Indium Zinc Tin Oxide (IZTO), Indium Aluminum Zinc Oxide (IAZO), Indium Gallium Zinc Oxide (IGZO), Indium Gallium Tin Oxide (IGTO), Antimony Tin Oxide (ATO), Gallium Zinc Oxide (GZO), IZO Nitride (IZON), ZnO, IrOₓ, RuOₓ, and NiO.

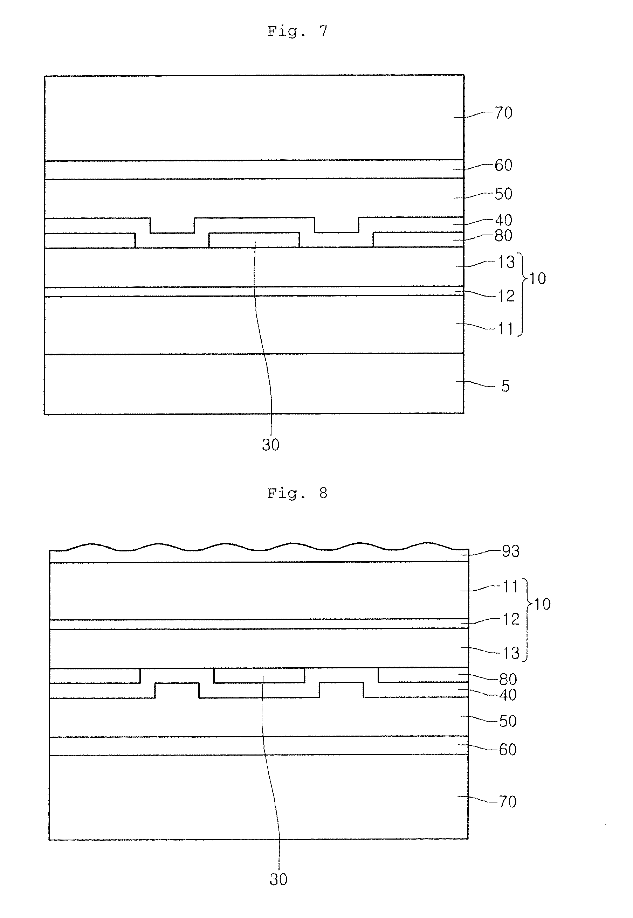

Then, as shown in Fig. 7, a reflective electrode 50, a bonding layer 60, and a conductive supporting member 70 are formed on the ohmic contact layer 40.

The reflective electrode 50 may be formed of a metallic material having high reflectivity. For example, the reflective electrode 50 may be formed of a metal or an alloy including at least one of Ag, Ni, Al, Rh, Pd, Ir, Ru, Mg, Zn, Pt, Cu, Au, and Hf. Moreover, the reflective electrode 50 may comprise a multilayer formed of the metal, the alloy, or a transparent conductive material such as Indium-Tin-Oxide (ITO), Indium-Zinc-Oxide (IZO), Indium-Zinc-Tin-Oxide (IZTO), Indium-Aluminum-Zinc-Oxide (IAZO), Ind ium-Gall ium-Zinc-Oxide (IGZO), Indium-Gallium-Tin-Oxide (IGTO), Aluminum-Zinc-Oxide (AZO), and Antimony-Tin-Oxide (ATO). For example, the reflective electrode 50 may comprise at least one of Ag, Al, Ag-Pd-Cu alloy, and a Ag-Cu alloy.

The bonding layer 60 may comprise a barrier metal or a bonding metal, and for example, may comprise at least one ofTi, Au, Sn, Ni, Cr, Ga, In, Bi, Cu, Ag and Ta. The conductive supporting member 70 supports a light emitting device according to an embodiment and is electrically connected to an external electrode to provide power to the light emitting structure 10. The conductive supporting member 70 may be formed of at least one of Ti, Cr, Ni, Al, Pt, Au, W, Cu, Mo, Cu-W or impurity injected carrier wafers, i.e., a semiconductor substrate formed of Si, Ge, GaN, GaAs, ZnO, SiC, or SiGe.

Then, the substrate 5 is removed from the light emitting structure 10. As one example, the substrate 5 may be removed through a Laser Lift Off (LLO) process. The LLO process is a process projecting laser on the bottom side of the substrate 5 to separate the substrate 5 from the light emitting structure 10.

Then, as shown in Fig. 8, an etching pattern 93 is formed on the first conductive semiconductor layer 11 of the light emitting structure 10.

The etching pattern 93 may be formed through a photolithography process, for example. The etching pattern 93 may be realized with a curve having a fine height difference according to a position through a gray scale phase mask technique for finely adjusting the light exposure intensity according to a position when the photolithography process is performed.

The etching pattern 93 may have a curved top surface with a continuous slope change. The top surface of the etching pattern 93 has a sectional upper side in a first direction having a curve with a continuous slope change and a sectional upper side in a second direction having a curve with a continuous slope change. Moreover, the top surface of the etching pattern 93 has a sectional upper side in a first direction having a curve with a continuous slope change and a sectional upper side in a second direction having a curve with a different continuous slope change. Herein, the second direction may be perpendicular to the first direction. Additionally, the second direction may have an arbitrary angle with respect to the first direction, not the right angle.

Moreover, the etching pattern 93 may have a top surface with a curve of a repeated predetermined shape. For example, the etching pattern 93 may have a top surface with a repeated wave-like shape. Additionally, the etching pattern 93 may have a top surface with repeated various shapes such as a spherical lens shape, a concave lens shape, a convex lens shape, and a lenticular lens shape.

For example, when the etching pattern 93 has a top surface with a concave sphere, a curved surface having a period of a height of about 1 µm to about 2 µm and a width of about 10 µm to about 50 µm may be formed.

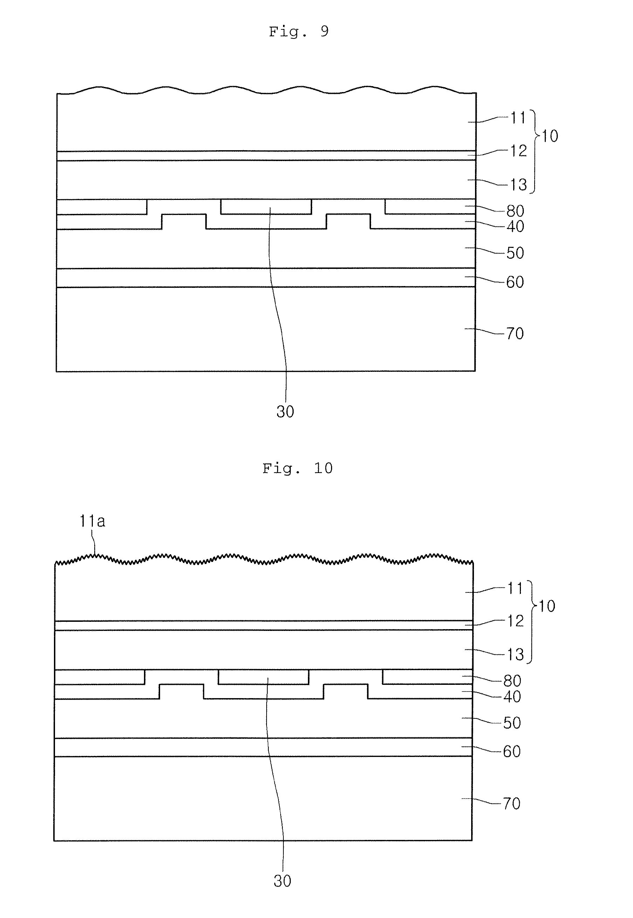

Then, as shown in Fig. 9, an etching process is performed on the first conductive semiconductor layer 11 of the light emitting structure 10, so that the top surface of the first conductive semiconductor layer 11 is formed with a curve having a continuous slope change.

The etching process may comprise a dry etching process, for example. The shape of the etching pattern 93 may be realized on the top surface of the first conductive semiconductor layer 11 through the etching process.

That is, the top surface of the first conductive semiconductor layer 11 may be realized with a curve having a continuous slope change corresponding to the top surface shape of the etching pattern 93. The top surface of the first conductive semiconductor layer 11 has a sectional upper side in a first direction having a curve with a continuous slope change and a sectional upper side in a second direction having a curve with a continuous slope change. Moreover, the top surface of the first conductive semiconductor layer 11 has a sectional upper side in a first direction having a curve with a continuous slope change and a sectional upper side in a second direction having lines with respectively different slopes. Herein, the second direction may be perpendicular to the first direction. Additionally, the second direction may have an arbitrary angle with respect to the first direction, not the right angle.

Moreover, the first conductive semiconductor layer 11 may have a top surface with a curve of a repeated predetermined shape. For example, the first conductive semiconductor layer 11 may have a top surface with a repeated wave-like shape. Additionally, the first conductive semiconductor layer 11 may have a top surface with repeated various shapes such as a spherical lens shape, a concave lens shape, a convex lens shape, and a lenticular lens shape.

For example, when the first conductive semiconductor layer 11 has a top surface with a concave sphere, a curved surface having a period of a height of about I µm to about 2 µm and a width of about 10 µm to about 50 µm may be formed.

Then, as shown in Fig. 10, an unevenness 11a is formed on the top surface of the first conductive semiconductor layer 11.

The unevenness 11a on the top surface of the first conductive semiconductor layer 11 may be formed through a wet etching process, for example. The unevenness 11a may have a height of about 0.8 µm to about 1.2 µm. Additionally, the unevenness 11a may be in a period of about 0.8 µm to about 1.2 µm. The unevenness 11a may be formed with a triangular section. Additionally, the unevenness 11a may be formed with a conical or hexagonal spatial shape. The shape of the unevenness 11a may be realized by reflecting a result of an etch rate difference according to characteristics of a crystal growth surface of the light emitting structure 10. For example, the triangular section of the unevenness 11a may be formed with a vertex protruding vertically from the surface.

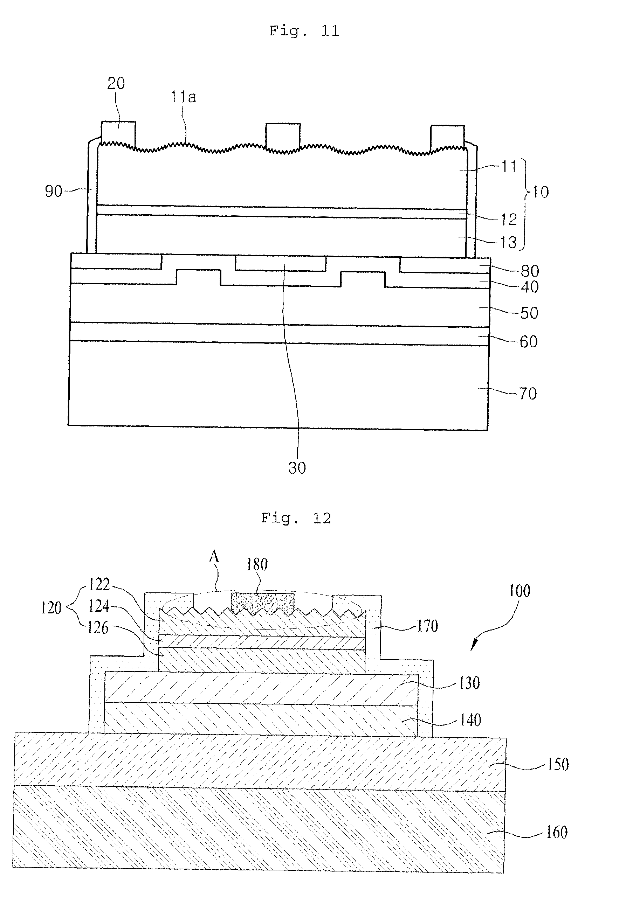

Then, as shown in Fig. 11, an isolation etching is performed along the boundary of each chip of the light emitting structure 10, so that a plurality of light emitting devices are divided by each light emitting device unit. The isolation etching may comprise dry etching such as Inductively Coupled Plasma (ICP), for example, but is not limited thereto.

Referring to Fig. 1l, the protective layer 90 may be disposed on at least the lateral side of the light emitting structure 10. The protective layer 90 may prevent the light emitting structure 10 from electrical short with an external electrode or the electrode 20.

The protective layer 90 may be formed of oxide or nitride, for example. The protective layer 90 may be formed of a material having transmittance and insulation such as SiO₂, SiOₓ, SiO_{X}N_{y}, Si₃N₄, and Al₂O₃. The protective layer 90 may be formed through a deposition method such as E-beam deposition, plasma-enhanced chemical vapor deposition (PECVD), and sputtering.

Then, an electrode 20 electrically connected to the light emitting structure 10 is formed. The electrode 20 together with the reflective electrode 50 may be formed to provide power to the light emitting structure 10, and to at least partially overlap the current blocking layer 31 in a vertical direction.

Moreover, Fig. 12 is a view of a light emitting device according to another embodiment.

The light emitting device 100 may comprise a bonding layer 150, a reflective layer 140, an ohmic layer 130, and a light emitting structure 120 on a conductive supporting substrate 160.

Since the conductive supporting substrate 160 may serve as a second electrode, it may be formed of a metal having excellent electrical conductivity. Since the conductive supporting substrate 160 needs to emit heat sufficiently during driving, it may be formed of a metal having high thermal conductivity.

The conductive supporting substrate 160 may be formed of a material selected from the group consisting of Mo, Si, W, Cu, Al, and an alloy thereof. The conductive supporting member 160 may be selectively formed of Au, Cu Alloy, Ni, Cu-W, and a carrier wafer (formed of GaN, Si, Ge, GaAs, ZnO, SiGe, SiC, SiGe, or Ga₂O₃)_{'}

Additionally, the conductive supporting substrate 160 may have the degree of mechanical strength, which prevents the entire nitride semiconductor from bending and provides each chip separation through a scribing process and a breaking process.

The bonding layer 150 combines the reflective layer 140 and the conductive supporting substrate 160. Additionally, the reflective layer 150 may serve as an adhesion layer. The bonding layer 150 may be formed of a material selected from the group consisting of Au, Sn In, Al, Si, Ag, Ni, and Cu.

The reflective layer 140 may have a thickness of about 2500 Å. The reflective layer 140 may be formed of a metal layer including an alloy including Al, Ag, Ni, Pt, and Rh, or Al, Ag, Pt, and Rh. Al or Ag may greatly improve the light extraction efficiency of a light emitting device by effectively reflecting the light from the active layer 124.

The light emitting structure 120, especially, the second conductive semiconductor layer 126, has low impurity doping concentration and high contact resistance. Due to this, ohmic characteristics may be poor. In order to improve the ohmic characteristics, an ohmic layer 130 may be formed. For example, the ohmic layer 130 may be formed of a transparent conductive oxide layer.

The ohmic layer 130 may have a thickness of about 200 Å. The ohmic layer 130 may be formed of at least one of indium tin oxide (ITO), indium zinc oxide (IZO), indium zinc tin oxide (IZTO), indium aluminum zinc oxide (IAZO), indium gallium zinc oxide (IGZO), indium gallium tin oxide (IGTO), aluminum zinc oxide (AZO), antimony tin oxide (ATO), gallium zinc oxide (GZO), IZO Nitride (IZON), Al-Ga ZnO (AGZO), In-Ga ZnO (IGZO), ZnO, IrOₓ, RuOₓ, NiO, RuOₓ/ITO, Ni/IrOₓ/Au, Ni/IrOₓ/Au/ITO, Ag, Ni, Cr, Ti, Al, Rh, Pd, Ir, Sn, In, Ru, Mg, Zn, Pt, Au, and Hf, but is not limited thereto.

The light emitting structure 120 may comprise a first conductive semiconductor layer 122, an active layer 124 below the first conductive semiconductor layer 122 to emit light, and a second conductive semiconductor layer 126 below the active layer 124.

The first conductive semiconductor layer 122 may be formed of a Group III-V compound semiconductor doped with a first conductive dopant. When the first conductive semiconductor layer 122 is an n-type semiconductor layer, the fist conductive dopant is an n-type dopant such as Si, Ge, Sn, Se, and Te, but is not limited thereto.

The first conductive semiconductor layer 122 may be formed of a compound semiconductor. The first conductive semiconductor layer 122 may be formed of semiconductor materials having the empirical formula, AlₓIn_{y}Ga_{(1-x-y)}N (0≤x≤1, 0≤y≤1, 0≤x+y≤1). The first conductive semiconductor layer 122 may be formed of at least one of GaN, InN, AlN, InGaN, AlGaN, InAlGaN, AlInN, AlGaAs, InGaAs, AlInGaAs, GaP, AlGaP, InGaP, AlInGaP, and InP.

A first electrode 180 may be formed on the surface of the first conductive semiconductor layer 122. The first electrode 180 may have a single or multilayer structure including at least one of Al, Ti, Cr, Ni, Cu, and Au. Then, unevenness may be formed on the surface of the light emitting structure 120, i.e., the surface of the first conductive semiconductor layer 122.

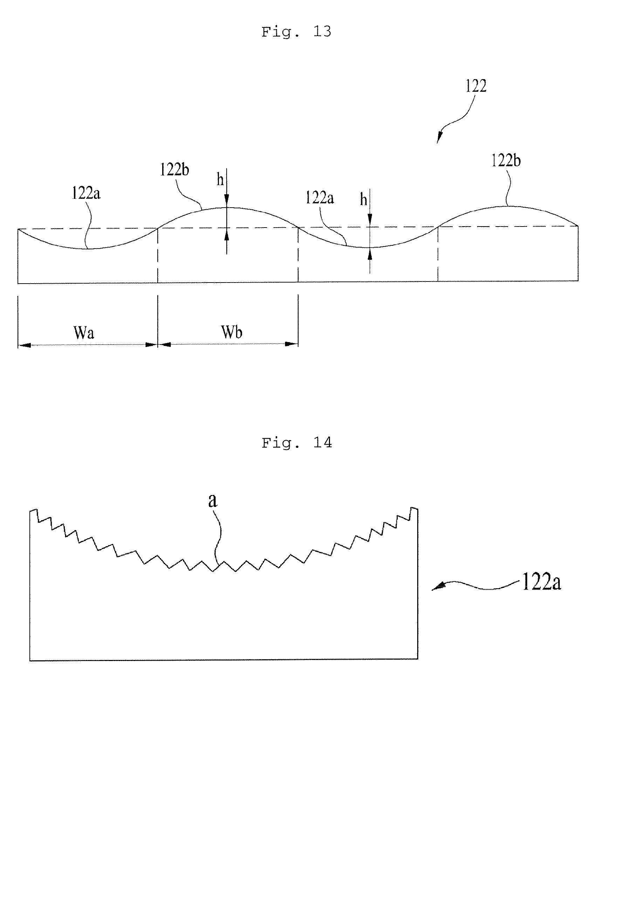

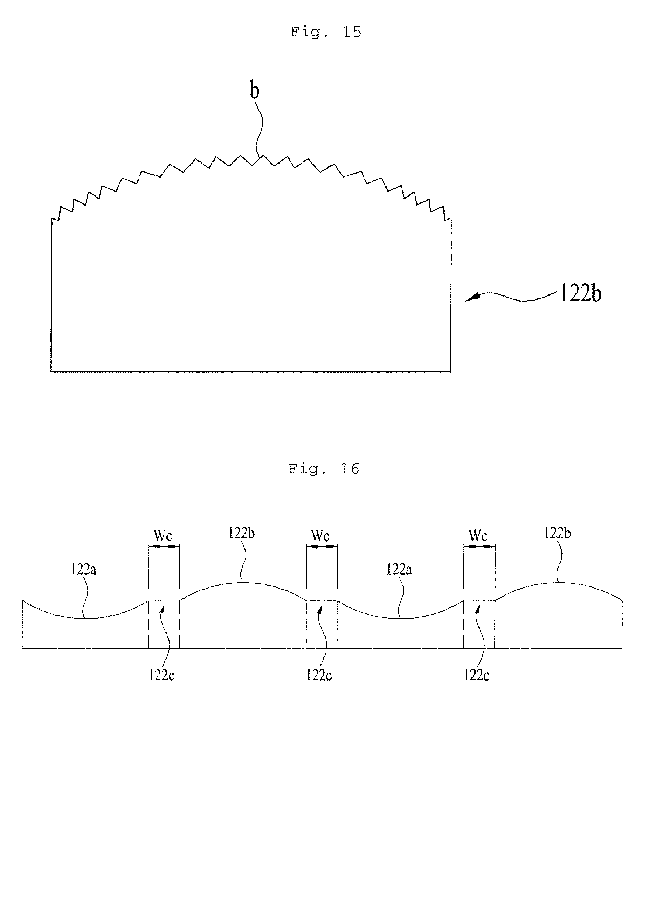

Fig. 13 is a view illustrating a structure of a portion A of Fig. 12. Fig. 14 is a view illustrating a structure of 122a of Fig. 13. Fig. 15 is a view illustrating a structure of 122b of Fig. 13.

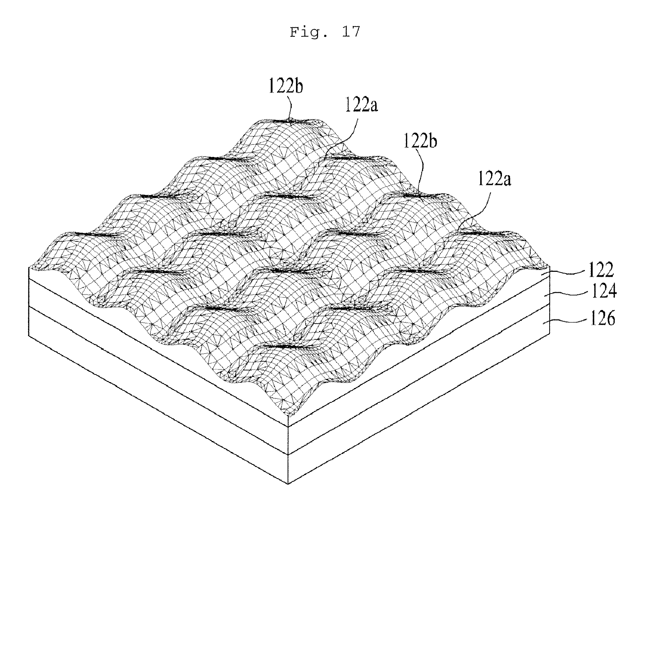

Fig. 17 is a perspective view of a light emitting structure having the structure of Fig. 13.

The surface of the light emitting structure 12 may comprise a first side 122a and a second side 122b. The first side 122a has a concave engraved shape below the reference plane indicated with a dotted line and the second side 122b has a convex embossed shape above the reference plane indicated with a dotted line, as shown in Fig. 13.

The first side 122a and the second side 122b having curvatures in respectively different directions, i.e., up and down directions, are alternately disposed on the light emitting structure 120, especially, on the surface of the first conductive semiconductor layer 122, as mentioned above.

The width of the first side 122a may be about 15 µm to about 25 µm and the width of the second side 122b may be the same as that of the first side 122a. The, the height h of the first side 122a may be about 0.5 µm to about 1.5 µm and the height of the second side 122b may be the same as that of the first side 122a.

Here, the depth of the first side 122a may be the vertical distance from the reference plane to the lowest point of the first side 122a, and the height of the second side 122b may be the vertical distance from the reference plane to the highest point of the second side 122b.

The first side 122a and the second side may have the same size and may be symmetric to each other with curvatures in different directions. The surfaces of the first side 122a and the second side 122b may have a spherical shape, each having a radius of about 45 µm to about 55 µm.

When the radius is 50 µm and the width of the first side 122a and the second side 122b is about 20 µm, the light vertically incident to the surface of the light emitting structure may be refracted at about 14.6 ° in the air when the refractive index of the light emitting structure is about 2.5. Then, the light is refracted by the light extraction pattern besides the surfaces of the first side 122a and the second side 122b, so that luminous flux and light distribution pattern may be increased on the whole.

Then, each of the first side 122a and the second side 122b may have a concave or convex micro lens shape as shown in Fig. 17. Accordingly, the surface of the light emitting structure 120 may have a micro lens array where a concave micro lens and a convex micro lens are alternately disposed.

In this embossed and engraved structure, embossing and engraving are alternately formed in a wave-like shape by dry-etching the surface of the light emitting structure with a gray scale phase mask.

As shown in Figs. 14 and 15, light extraction patterns a and b are formed on the surface of the first side 122a and the surface of the second side 122b, respectively. That is, the patterns a and b are formed in order not to totally reflect the emitted light from the active layer 124 at the surface of the light emitting structure 120, so that the light distribution pattern of the light emitted from the light emitting device to the external may be broader.

Especially, compared to a parallel light emitting device, a vertical light emitting device may provide the more amount of light by about 20 % to about 30 % relatively but its light amount may be reduced after packaging. Thus, as mentioned above, it is effective to broad the light distribution pattern.

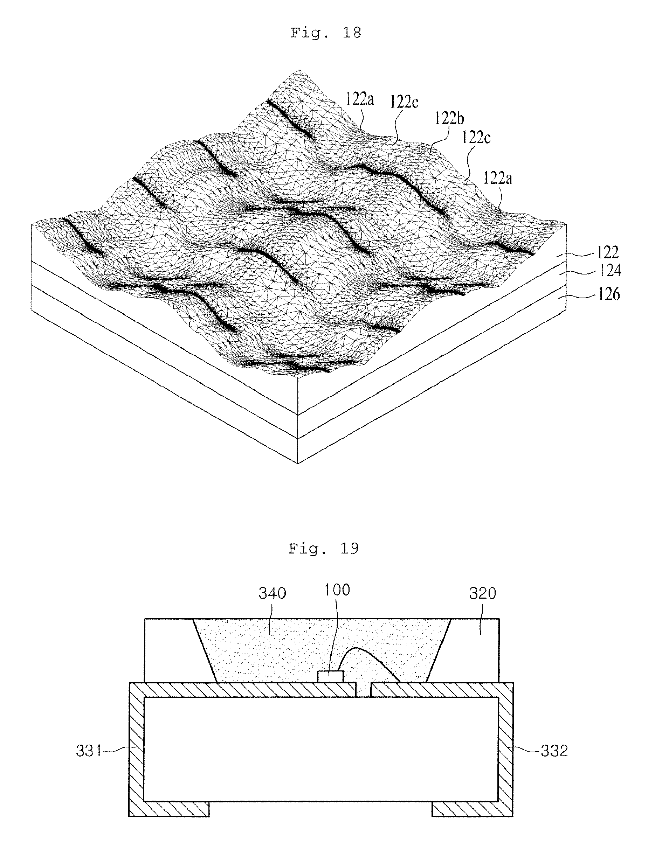

Fig. 16 is a view illustrating another structure of the portion A of Fig. 12. Fig. 18 is a perspective view of a light emitting structure having the structure of Fig. 16.

This embodiment may be similar to that of Fig. 13. However, a third side 122c may be disposed between the first side 122a and the second side 122b, and may have a flat side without a curvature.

Although the third side 122c is between the first and second sides 122a and 122b, it may not necessarily be disposed between all the first and second sides 122a and 122b.

Then, a passivation layer 170 may be formed on the lateral side of the light emitting structure 120. The passivation layer 170 may be formed of an insulating material, which may comprise nonconductive oxide or nitride. As one example, the passivation layer 170 may comprise a silicon oxide (SiO₂) layer, an oxide nitride layer, and an oxide aluminum layer.

Additionally, the first conductive semiconductor layer 122 may be a p-type semiconductor layer and the second conductive semiconductor layer 126 may be an n-type semiconductor layer. Additionally, when the second conductive semiconductor layer is a p-type semiconductor layer, an n-type semiconductor layer having an opposite polarity to the second conductive semiconductor 126 may be formed on the second conductive semiconductor layer 126. Accordingly, the light emitting structure may have one of an N-P junction structure, a P-N junction structure, an N-P-N junction structure, and a P-N-P junction structure.

Fig. 19 is a view of a light emitting device package having a light emitting device applied according to an embodiment.

Referring to Fig. 19, the light emitting device package comprises a main body 320, a first lead electrode 331 and a second lead electrode 332 on the main body 320, a light emitting device 100 electrically connected to the first and second lead electrodes 331 and 332 in the main body 320, and a molding member 340 surrounding the light emitting device 100.

The main body 320 may be formed of silicon material, synthetic material, or metallic material, and may be formed with an inclined plane around the light emitting device 100.

The first lead electrode 331 and the second lead electrode 332 may be electrically separated from each other and provide power to the light emitting device 100. Additionally, the first lead electrode 331 and the second lead electrode 332 reflects the light generated from the light emitting device 100 to increase light efficiency and may also serve to emit the heat generated from the light emitting device 100 to the external.

The light emitting device 100 may be disposed on the main body 320 or on the first lead electrode 331 or the second lead electrode 332.

The light emitting device 100 may be electrically connected to the first lead electrode 331 and the second lead electrode 332 through one of a wire method, a flip chip method, and a die bonding method.

The bonding member 340 may surround the light emitting device 100 to protect it. Additionally, the molding member 340 may comprise a fluorescent substance to change the wavelength of the light emitted from the light emitting device 100.

A plurality of light emitting devices or light emitting device packages may be arrayed on a board, and an optical member such as a lens, a waveguide plate, a prism sheet, and a diffusion sheet may be disposed on an optical path of the light emitting device package. This light emitting device package, board, and optical member may serves as a light unit. The light unit may comprise a top or side view type and may be provided to a display device such as portable terminals and notebook computers, or may be applied to the lighting devices and pointing devices. According to another embodiment, a lighting device including the semiconductor light emitting device or the light emitting device package mentioned in the above embodiments may be realized. For example, the lighting device may comprise a lamp, a streetlight, an electronic scoreboard, and a headlight.

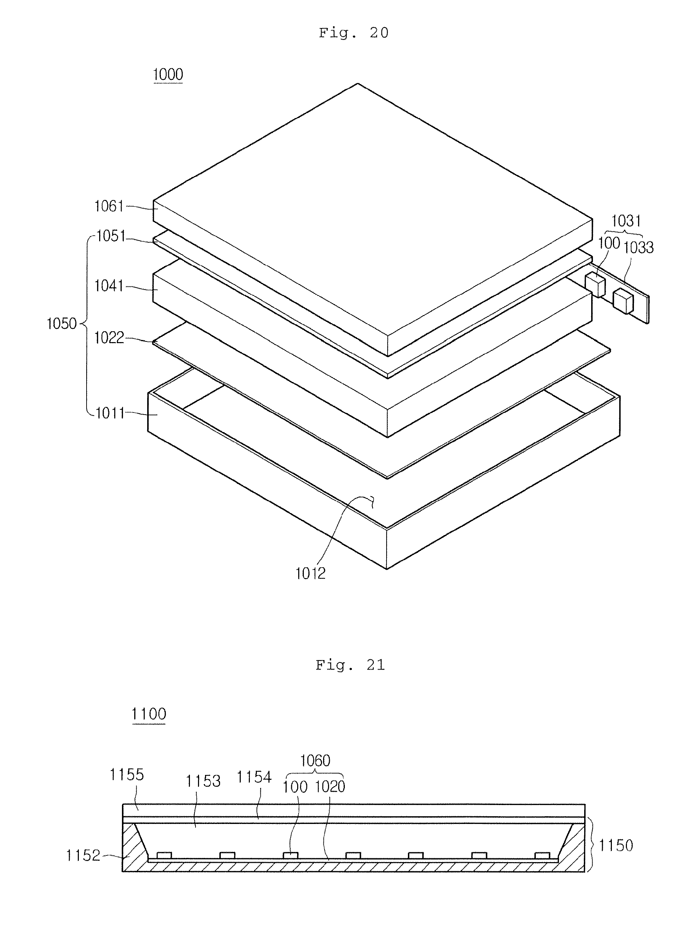

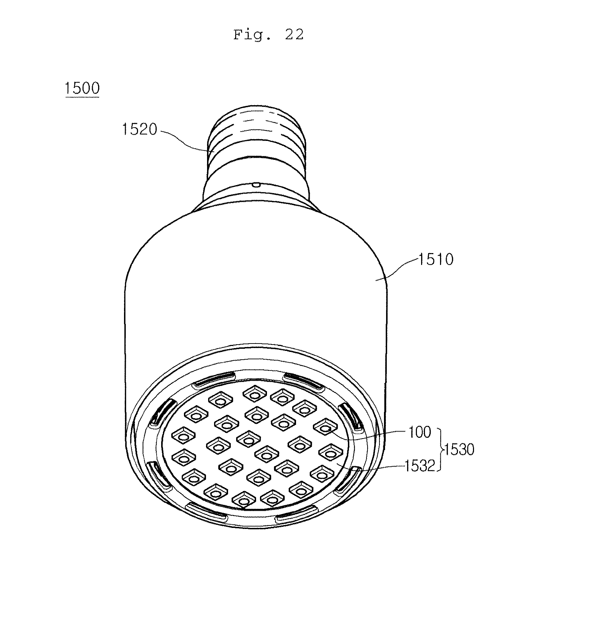

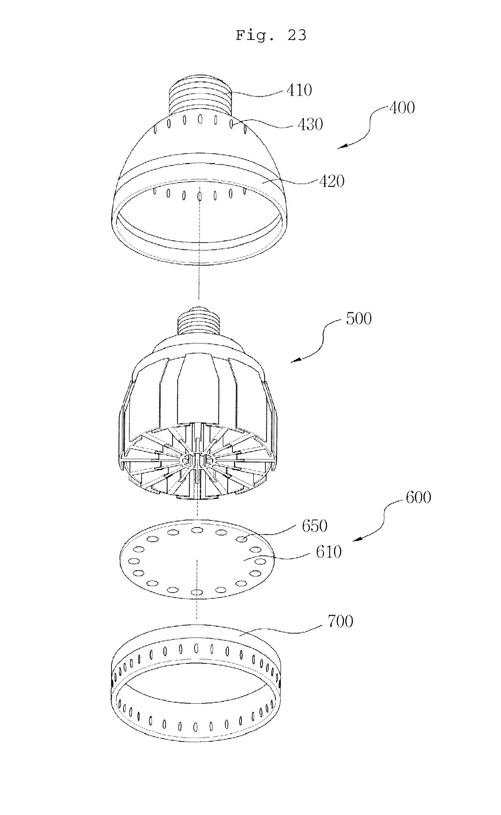

The light emitting device may be applied to a light unit. The light unit may have a structure where a plurality of light emitting devices are arrayed, and may comprise a display device shown in Figs. 20 and 21 and a lighting device shown in Figs. 22 and 23.

Referring to Fig. 20, the display device 1000 may comprise a light guide plate 1041, a light emitting module 1031 providing light to the light guide plate 1041, a reflective member 1022 below the light guide plate 1041, an optical sheet 1051 on the light guide plate 1041, a display panel 1061 on the optical sheet 1051, and a bottom cover 1011 receiving the light guide plate 1041, the light emitting module 1031, and the reflective member 1022, but is not limited thereto.

As one embodiment, the bottom cover 1011, the reflective sheet 1022, the light guide plate 1041, and the optical sheet 1051 may be defined as a light unit 1050.

The light guide plate 1041 diffuses light to become a surface light source. The light guide plate 1041 may be formed of transparent material, and may comprise one of acrylic resin series such as polymethyl metaacrylate, and polyethylene terephthlate (PET), poly carbonate (PC), cycloolefin copolymer (COC), and polyethylene naphthalate (PEN) resins.

The light emitting module 1031 provides light to at least one lateral side of the light guide plate 1041, and ultimately serves as a light source of the display device.

At least one light emitting module 1031 may be provided and may directly or indirectly provide light at one lateral side of the light guide plate 1041. The light emitting module 1031 may comprise a board 1033 and the light emitting devices 100 described in the above embodiment. The light emitting devices 100 may be arrayed with a predetermined interval on the board 1033.

The board 1033 may be a Printed Circuit Board (PCB) including a circuit pattern. However, the board 1033 may comprise a typical PCB, a Metal Core PCB (MCPCB), and a Flexible PCB (FPCB), but is not limited thereto. If the light emitting device 100 is provided on the lateral side of the bottom cover 1011 or a heat sink plate, the board 1033 may be removed. Here, a portion of the heat sink plate may contact the upper side of the bottom cover 1011.

Moreover, the plurality of light emitting devices 100 may have outgoing sides from which light is emitted, and are spaced a predetermined distance apart from the light guide plate 1041, but are not limited thereto. The light emitting device 100 may directly or indirectly provide light to a light entering part, i.e., one lateral side of the light guide plate 1041, but is not limited thereto.

The reflective member 1022 may be disposed below the light guide plate 1041. The reflective member 1022 may reflect the light, incident to the bottom side of the light guide plate 1041, toward the top side, thereby improving the brightness of the light unit 1050. The reflective member 1022 may be formed of PET, PC, PVC resins, for example, but is not limited thereto. The reflective member 1022 may be the upper side of the bottom cover 1011, but is not limited thereto.

The bottom cover 1011 may receive the light guide plate 1041, the light emitting module 1031, and the reflective member 1022. For this, the bottom cover 1011 may comprise a receiving part 1022 having a box shape with the upper side open, but is not limited thereto. The bottom cover 1011 may be coupled to the top cover, but is not limited thereto.

The bottom cover 101 may be formed of metallic material or a resin material, and may be manufactured through a process such as press molding or extrusion molding. Additionally, the bottom cover 1011 may comprise a metallic or nonmetallic material having excellent thermal conductivity, but is not limited thereto.

The display panel 1061 may comprise transparent first and second substrates facing each other, and a liquid crystal layer interposed therebetween, as an LCD panel. A polarizing plate may be attached to at least one side of the display panel 1061, but the present invention is not limited to this attachment structure of the polarizing plate. The display panel 1061 may display information by using the light passing through the optical sheet 1051. The display device 1000 may be applied to various portable terminals, monitors of notebook computers, and televisions.

The optical sheet 1051 is disposed between the display panel 1061 and the light guide plate 1041, and comprises at least one transparent sheet. The optical sheet 1051 may comprise at least one of a diffusion sheet, a parallel and vertical prism sheet, and a brightness enhancing sheet. The diffusion sheet diffuses incident light. The parallel or/and vertical prism sheet concentrates incident light on a display area. The brightness enhancing sheet reuses the light to be lost to improve brightness. Additionally, a protective sheet may be disposed on the display panel 1061, but the present invention is not limited thereto.

Here, at least one of the light guide plate 1041 and the optical sheet 1051 may be disposed as an optical member on an optical path of the light emitting module 1031, but the present invention is not limited thereto.

Fig. 21 is a view illustrating another example of a display device according to an embodiment.

Referring to Fig. 21, the display device 1100 may comprise a bottom cover 1152, a board 1020 having the above disclosed light emitting devices 100 arrayed, an optical member 1154, and a display panel 1155.

The board 1020 and the light emitting device 100s may be defined as a light emitting module 1060. The bottom cover 1152, at least one light emitting module 1060, and an optical member 1154 may be defined as a light unit.

The bottom cover 1152 may comprise a receiving part 1153, but is not limited thereto.

Here, the optical member 1154 may comprise at least one of a lens, a light guide plate, a diffusion sheet, a parallel and vertical prism sheet, and a brightness enhancing sheet. The light guide plate may be formed of a PC material or a PMMA material, and may be removed if necessary. The diffusion sheet diffuses incident light. The parallel and vertical prism sheet concentrates incident light on a display area. The brightness enhancing sheet reuses the light to be lost to improve brightness.

The optical member 1154 is disposed on the light emitting module 1160 and allows the light emitted from the light emitting module 1160 to be a surface light source, or diffuses or concentrates the light.

Fig. 22 is a perspective view of a lighting device according to an embodiment.

Referring to Fig. 22, the lighting device 1500 may comprise a case 1510, a light emitting module 1530 installed at the case 1510, and a connection terminal 1520 installed at the case 1510 and receiving power from an external power source.

The case 1510 may be formed of a material having excellent heat dissipation, and for example, a metallic or resin material.

The light emitting module 1530 may comprise a board 1532 and the light emitting devices 100 described in the above embodiment on the board 1532. The plurality of light emitting devices 100 may be arrayed in a matrix or may be arrayed being spaced a predetermined interval from each other.

The board 1532 may be a board having a circuit pattern printed on an insulator, and for example, may comprise a typical PCB, a MCPCB, a FPCB, a ceramic PCB, and an FR-4 board.

Additionally, the board 1532 may be formed of a material for efficiently reflecting light, or may have a surface including a coating layer with colors such as white and silver that efficiently reflecting light.

At least one light emitting device 100 may be disposed on the board 1532. Each light emitting device 100 may comprise at least one Light Emitting Diode (LED) chip. The LED chip may comprise a colored LED for emitting red, green, blue, or white, and an UV LED for emitting UltraViolet (UV).

The light emitting module 1530 may be disposed with various combinations of the light emitting devices 100 to obtain color sense and brightness. For example, a white LED, a red LED, and a green LED are disposed and combined to obtain a high color rendering index.

The connection terminal 1520 is electrically connected to the light emitting module 1530 to provide power to it. The connection terminal 1520 is coupled to an external power in a socket type, but is not limited thereto. For example, the connection terminal 1520 may have a pin shape, and thus, may be inserted into an external power or may be connected to an external power through wiring.

According to an embodiment, after the light emitting devices 100 are packaged, and then, are mounted on the board to form a light emitting module, or are mounted in an LED chip and packaged to form a light emitting module.

Fig. 23 is a view illustrating another example of a lighting device having a display device applied according to an embodiment.

The lighting device may comprise a light source 600 projecting light, a housing 400 having the light source 600 embedded, a heat sink part 500 emitting the heat of the light source 600, and a holder 700 coupling the light source 600 and the heat sink part 500 to the housing 400.

The housing 400 may comprise a socket coupling part 410 to be coupled to an electrical socket, and a main body 420 connected to the socket coupling part 410 and including the light source 600. An air flow hole 430 may penetrates the main body 420.

The main body 420 of the housing 400 may comprise a plurality of air flow holes 430. One air flow hole 430 may be provided or a plurality of air flow holes 430 may be provided in a radial shape as shown in the drawing, but the present invention is not limited thereto.

The light source 600 may comprise a circuit board 610 and a plurality of light emitting device packages 650 on the circuit board 610. Here, the circuit board 610 may be inserted into the opening part of the housing 400. Additionally, the circuit board 610 may be formed of a material having a high thermal conductivity to emit the heat to the heat sink part 500.

The holder 700 may be disposed below the light source 600. The holder 700 may comprise a frame and another air flow hole. Moreover, although not shown in the drawings, an optical member is disposed below the light source 600 to diffuse, scatter, or concentrate the light projected from the light emitting device package 650 of the light source 600.

In the above-mentioned lighting device, embossed and engraved patterns are formed on the surface of the light emitting structure in the light emitting device package and unevenness is formed on the surface of the micro lens having the embossed and engraved patterns. Due to this, the emission angle of the light emitted from the active layer becomes broader and light attenuation is prevented. As a result, light efficiency is improved.

Embodiments of the present invention provide a light emitting device, a light emitting device package, and a light unit, with a new structure.

Embodiments of the present invention provide a light emitting device, a light emitting device package, and a light unit, with improved light extraction efficiency and broad angle for light extraction.

Additionally, the features, structures, and effects described in the above embodiments are included in at least one embodiment, but the present invention is not limited thereto. Furthermore, the features, structures, and effects in each embodiment may be combined or modified for other embodiments by those skilled in the art. Accordingly, contents regarding the combination and modification should be construed as being in the scope of the present invention.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A light emitting device comprising:
a light emitting structure comprising a first conductive semiconductor layer, an active layer below the first conductive semiconductor layer, and a second conductive semiconductor layer below the active layer;
a first electrode electrically connected to the first conductive semiconductor layer; and
a second electrode electrically connected to the second conductive semiconductor layer,
wherein a top surface of the first conductive semiconductor layer has a curve with a slope change and an unevenness is provided on a top surface of the first conductive semiconductor layer.

2. The light emitting device according to claim I, wherein the top surface of the first conductive semiconductor layer has a sectional upper side in a first direction having a curve with a continuous slope change and a sectional upper side in a second direction having a curve with a continuous slope change.

3. The light emitting device according to claim 1, wherein the top surface of the first conductive semiconductor layer has a sectional upper side in a first direction having a curve with a continuous slope change and a sectional upper side in a second direction having lines with respectively different slopes.

4. The light emitting device according to any one of claims 1 to 3, wherein the top surface of the first conductive semiconductor layer has a curved surface of a repeated predetermined shape.

5. The light emitting device according to any one of claims I to 4, wherein the unevenness has a height of 0.8 µm to 1.2 µm.

6. The light emitting device according to any one of claims I to 5, wherein the unevenness has a period of 0.8 µm to 1.2 µm.

7. The light emitting device according to any one of claims 1 to 6, further comprising a current blocking layer below the second conductive semiconductor layer.

8. The light emitting device according to claim 7, further comprising an ohmic contact layer between the second conductive semiconductor layer and the second electrode and between the current blocking layer and the second electrode.

9. The light emitting device according to claim 7 or 8, wherein the current blocking layer and the first electrode partially overlap each other in a vertical direction.

10. The light emitting device according to any one of claims 7 to 9, wherein the current blocking layer has electrical insulation or provides Schottky contact with the light emitting structure.

11. The light emitting device according to any one of claims 1 to 10, wherein the first electrode contacts the first conductive semiconductor layer.

12. The light emitting device according to any one of claims I to 11, wherein the second electrode contacts the second conductive semiconductor layer.

13. A light emitting device package comprising:
a main body;
the light emitting device of any one of claims I to 12 disposed on the main body; and
first and second lead electrodes electrically connected to the light emitting device.

14. A light unit comprising:
a board;
the light emitting device of any one of claims 1 to 12 disposed on the board; and
an optical member through which a light from the light emitting device passes.
